# EUROPEAN PATENT APPLICATION

(11) **EP 4 794 489 A1**
(43) Date of publication of application: **19.08.2026**
(21) Application number: 24876824.4
(22) Date of filing: 12.11.2024
(51) Int. Cl.: H10F 71/00, H10F 19/00

(54) **APPARATUS FOR MANUFACTURING SOLAR CELL AND METHOD FOR MANUFACTURING SOLAR CELL**

(30) Priority: 11.10.2023 KR 20230134845
(71) Applicant: Hanwha Solutions Corporation, Seoul 04541 (KR)
(72) Inventor: JUNG, Min Kyo, Seoul 04541 (KR); BAEK, Dong Heon, Seoul 04541 (KR); JEON, Sung Gyu, Seoul 04541 (KR); CHUNG, Dong Jin, Seoul 04541 (KR)
(74) Representative: Mooser, Sebastian Thomas
(86) International application number: PCT/IB2024/061213
(87) International publication number: WO 2025/079058

(57) **Abstract**

A solar cell manufacturing apparatus includes: a solar cell on which a wire is disposed; a stage on which the solar cell is seated; and a shaft disposed under the stage to be placed on a traveling path of the stage, wherein the stage includes: a body; a plate disposed within the body to move upwards or downwards and adjoining the shaft disposed under the stage; and a plurality of pins seated on an upper surface of the plate, and wherein, upon movement of the stage, the stage is moved to be mounted on the shaft, the shaft pushes the plate upwards with the plurality of pins seated on the plate, and upper surfaces of the plurality of pins bring the wire into contact with a lower surface of the solar cell while moving upwards.

## Description

### [Technical Field]

Embodiments of the present invention relate to a solar cell manufacturing apparatus and a solar cell manufacturing method.

### [Background Art]

A solar cell is formed by disposing a diode having a p-n junction on a substrate. When sunlight reaches a solar cell, the solar cell creates an exciton, that is, an electron-hole pair, and the exciton splits into electrons and holes, which migrate to an n-layer and to a p-layer, respectively, thereby generating photovoltaic electricity across the p-n junction. Tabbing refers to a process of forming a single solar cell module through electrical connection of multiple solar cells to one another by placing wires on the solar cells.

Here, a process of bonding the solar cells and the wires includes applying an electrically conductive adhesive (ECA) to the surfaces of the solar cells and bonding the wires to the solar cells.

The process of bonding the solar cells to the wires using the electrically conductive adhesive is a next generation process for manufacturing solar cells and various studies have been conducted on specific embodiments thereof.

### [Disclosure]

### [Technical Problem]

It is an object of the present invention to provide a solar cell manufacturing apparatus and a solar cell manufacturing method including a process of bonding a solar cell and a wire using an adhesive.

The above object is provided by way of example and the present invention is not limited thereto.

### [Technical Solution]

1. One aspect of the present invention relates to a solar cell manufacturing apparatus. The solar cell manufacturing apparatus includes: a solar cell on which a wire is disposed; a stage on which the solar cell is seated; and a shaft disposed under the stage to be placed on a traveling path of the stage, wherein the stage includes: a body; a plate disposed within the body to move upwards or downwards and adjoining the shaft disposed under the stage; and a plurality of pins seated on an upper surface of the plate, and wherein, upon movement of the stage, the stage is moved to be mounted on the shaft, the shaft pushes the plate upwards with the plurality of pins seated on the plate, and upper surfaces of the plurality of pins bring the wire into contact with a lower surface of the solar cell while moving upwards.
2. In embodiment 1, the shaft may be formed at a distal end thereof with a chamfered portion and the stage may mount on the shaft along the chamfered portion.
3. In embodiment 1, the solar cell manufacturing apparatus may further include a jig configured to press an upper surface of the solar cell, the jig being brought into contact with the upper surface of the solar cell.
4. In embodiment 1, the solar cell may include: a surface portion; a plurality of wires disposed on the surface portion thereof; and a plurality of electrically conductive adhesive members disposed between the plurality of wires and the surface portion and spaced apart from each other.
5. In embodiment 4, the plurality of pins may be disposed at locations corresponding to the plurality of electrically conductive adhesive members.
6. In embodiment 1, the body may include: a wire insertion hole into which a wire disposed on the solar cell is inserted; and pin insertion holes into which the plurality of pins is inserted.
7. In embodiment 6, the wire insertion hole may have a depth (h) ranging from about 5 times to about 10 times a width of the wire.
8. In embodiment 1, each of the plurality of pins may have a diameter ranging from about 3 times to about 5 times the width of the wire.
9. In embodiment 1, a thickness (t3) between the upper surfaces of the plurality of pins moved upwards and an upper surface of the stage may be less than a thickness (t2) of the wire.
10. Another aspect of the present invention relates to a solar cell manufacturing method. The solar cell manufacturing method includes: feeding a stage; feeding a wire onto the stage; feeding a solar cell and a jig onto the stage fed the wire; pre-heating the solar cell and the jig on the stage; curing the solar cell and the jig on the stage; and discharging the solar cell, wherein the step of pre-heating the solar cell and the jig on the stage includes raising a plurality of pins to press the wire.
11. In embodiment 10, the stage may include: a body; a plate disposed within the body to move upwards or downwards and adjoining a shaft disposed under the stage; and a plurality of pins seated on an upper surface of the plate.
12. In embodiment 11, the step of pre-heating the solar cell and the jig on the stage may include: moving the stage to an upper side of the shaft; and moving the plate upwards, and the step of raising a plurality of pins to press the wire may include moving the plurality of pins disposed on the plate upwards to press the wire disposed between the plurality of pins and the solar cell towards a lower surface of the solar cell.
13. In embodiment 12, the solar cell manufacturing method may further include: post-heating the solar cell and the jig between the step of curing the solar cell and the jig on the stage and the step of discharging the solar cell, wherein the plurality of pins may press the wire toward the lower surface of the solar cell even in the step of post-heating.

The above and other aspects, features, and advantages of the present invention will become apparent from the detailed description, claims, and drawings for practicing the invention.

### [Advantageous Effects]

In a solar cell manufacturing apparatus and a solar cell manufacturing method according to embodiments of the present invention, upon entering a soldering zone, a plurality of pins in a stage is raised through a shaft and presses wires against to contact a surface of a solar cell, whereby the wires can be brought into stable contact with the surface of the solar cell using a mechanical structure without a separate power source.

The effects of the present invention are not limited to the aforementioned effect and other effects not mentioned will become apparent to those skilled in the art from the claims.

### [Description of Drawings]

FIG. 1 is an overall conceptual view of a solar cell manufacturing apparatus according to one embodiment of the present invention.
FIG. 2 is a view sequentially illustrating a process of connecting solar cells and wires according to one embodiment of the present invention.
FIG. 3 is a perspective view of a solar cell manufacturing apparatus according to one embodiment of the present invention.
FIG. 4 is a perspective view of the solar cell manufacturing apparatus including the curing unit according to one embodiment of the present invention, illustrating a stage placed therein.
FIG. 5 is a bottom view of Part A1 of FIG. 4, that is, the curing unit.
FIG. 6 is a top view of Part A2 of FIG. 4, that is, a base.
FIG. 7 is an enlarged view of Part B of FIG. 4.
FIG. 8 is a side view of the stage according to the embodiment of the present invention, showing the stage moved to be mounted on a shaft.
FIG. 9 is a perspective view of the solar cell manufacturing apparatus according to the embodiment of the present invention before the stage is mounted on the shaft.
FIG. 10 is an exploded perspective view of the stage and a solar cell seated on the stage shown in FIG. 9.
FIG. 11 is a perspective view of the solar cell manufacturing apparatus according to the embodiment of the present invention after the stage is mounted on the shaft.
FIG. 12 is an exploded perspective view of the stage and a solar cell seated on the stage shown in FIG. 11.
FIG. 13 is a cross-sectional view taken along line A-A of FIG. 10, showing the stage before the stage is mounted on the shaft.
FIG. 14 is a cross-sectional view taken along line B-B of FIG. 12, showing the stage after the stage is mounted on the shaft.
FIG. 15 is a cross-sectional view taken along line C-C of FIG. 9, showing the stage before the stage is mounted on the shaft.
FIG. 16 is a cross-sectional view taken along line D-D of FIG. 11, showing the stage after the stage is mounted on the shaft.
FIG. 17 is an enlarged perspective view of Part E of FIG. 12, showing the pins moved upwards.
FIG. 18(a) is an enlarged cross-sectional view of Part E of FIG. 12, showing a thickness of each component with the pin moved downwards. FIG. 18(b) is an enlarged cross-sectional view of Part E of FIG. 12, showing the thickness of each component with the pin moved upwards.
FIG. 19 is a flowchart illustrating a solar cell manufacturing method according to one embodiment of the present invention.

### [Best Mode]

The present invention can be modified in various ways and can have various embodiments, some of which are illustrated in the drawings and described in detail in the following description of the invention. However, it should be understood that it is not intended to limit the present invention to any particular embodiments and the present invention includes all modifications, equivalents, or substitutions that fall within the scope of the present invention. In description of the invention, the same components will be denoted by the same reference numerals throughout the specification.

Hereinafter, exemplary embodiments of the present invention will be described in detail with reference to the accompanying drawings, in which the same or corresponding components will be denoted by the same reference numerals and repeated description thereof will be omitted.

In the following embodiments, the terms "first", "second", and the like are not intended to be limiting, but are used to distinguish one element from another element.

In the following embodiments, the singular forms "a", "an" and "the" are intended to include the plural forms as well, unless the context clearly indicates otherwise.

In the following embodiments, the terms "includes," "including," "comprises," and/or "comprising," when used in this specification, specify the presence of stated features or components but do not preclude the presence or addition of one or more other features or components.

In the drawings, dimensions of various elements, layers, etc. may be exaggerated or reduced for clarity of illustration. For example, the size and thickness of each element shown in the drawings is arbitrarily shown for ease of description and the present invention is not limited thereto.

When an exemplary embodiment is implemented differently, a specific process order may be performed differently from the described order. For example, two consecutively described processes may be performed substantially at the same time or performed in an order opposite the described order.

The terminology used herein is for the purpose of describing particular embodiments and is not intended to be limiting. Moreover, the terms "includes," "including," "comprises," and/or "comprising," when used in this specification, specify the presence of stated features, integers, steps, operations, elements, components and/or groups thereof but do not preclude the presence or addition of one or more other features, integers, steps, operations, elements, components, and/or groups thereof.

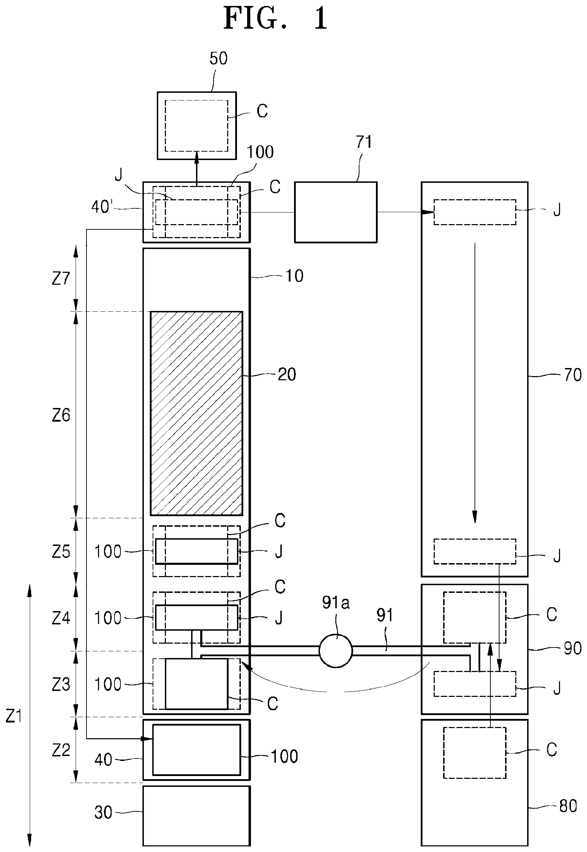

Hereinafter, a solar cell manufacturing apparatus according to one embodiment of the present invention will be described with reference to FIG. 1 to FIG. 16.

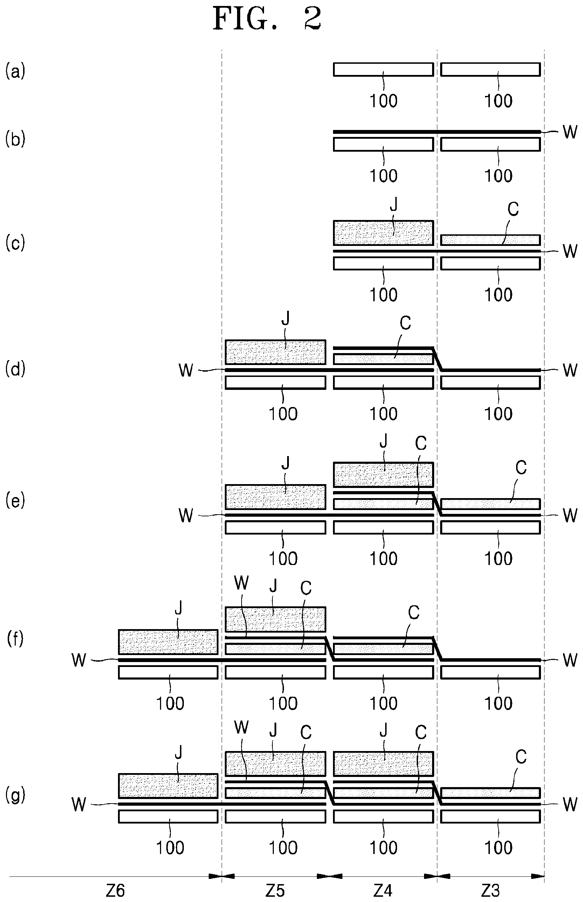

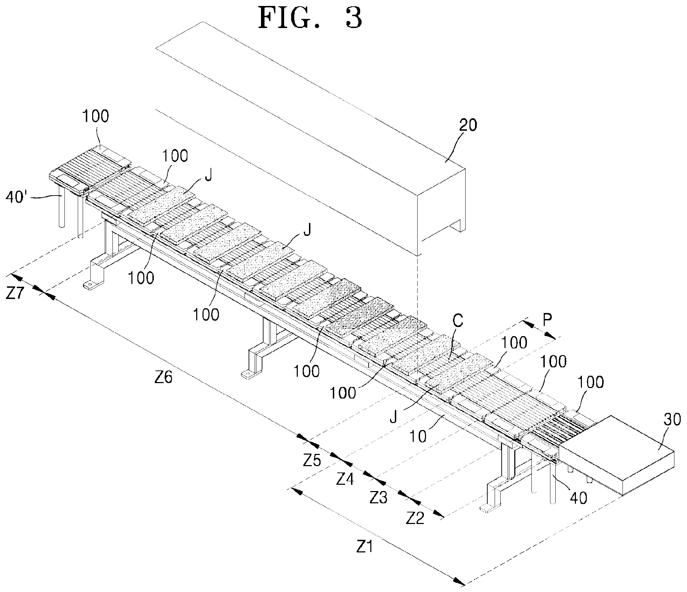

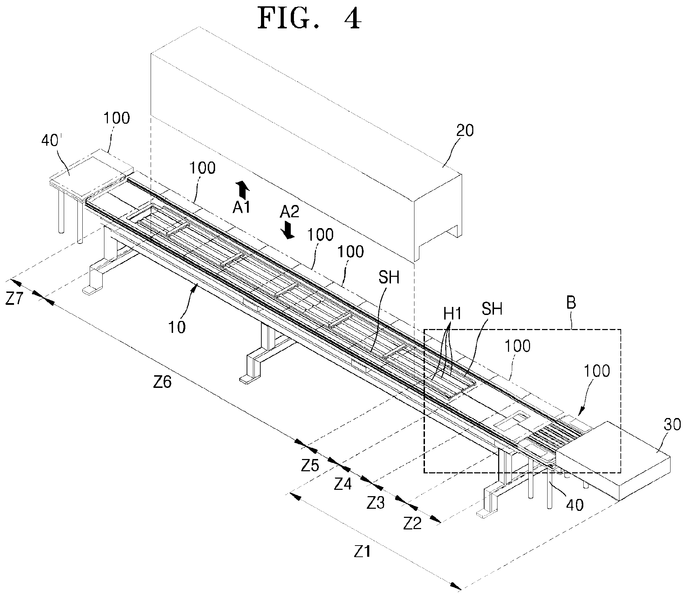

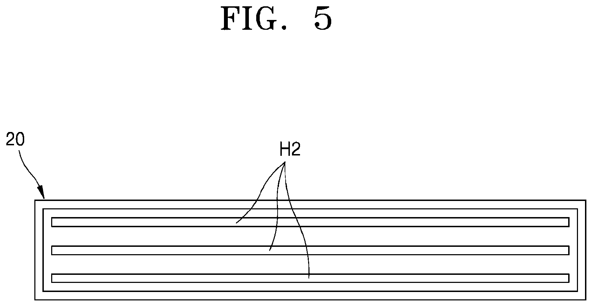

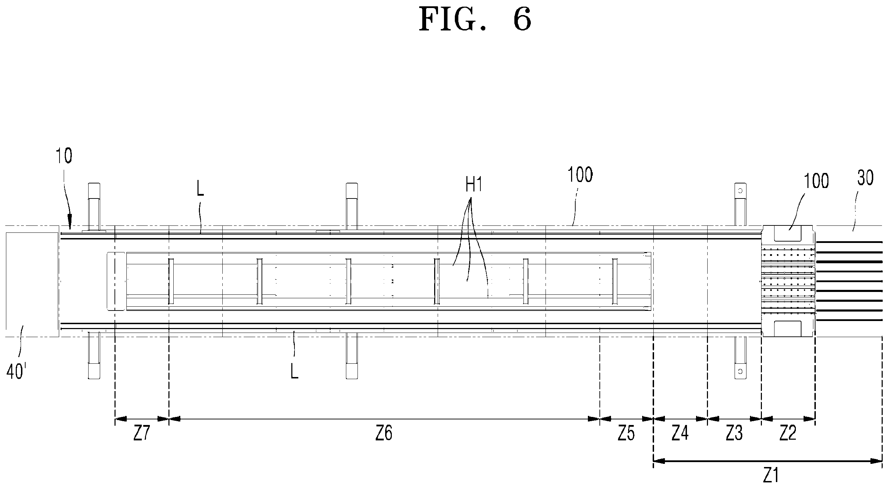

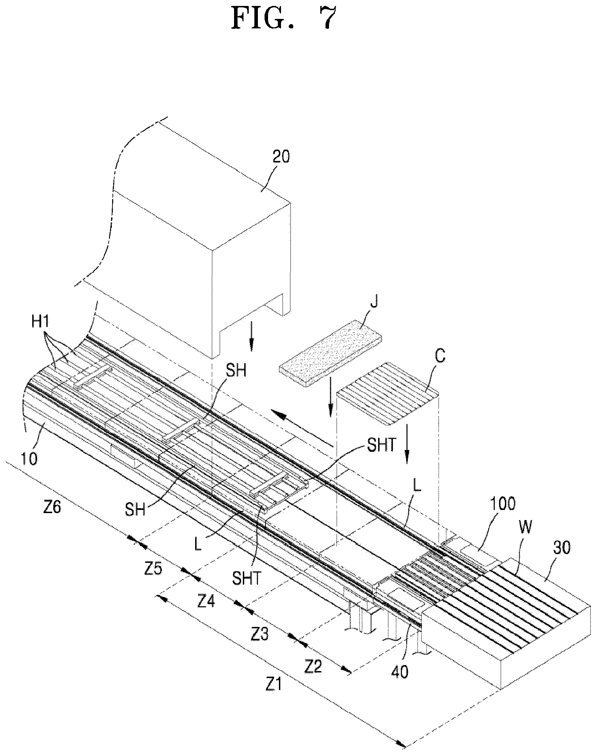

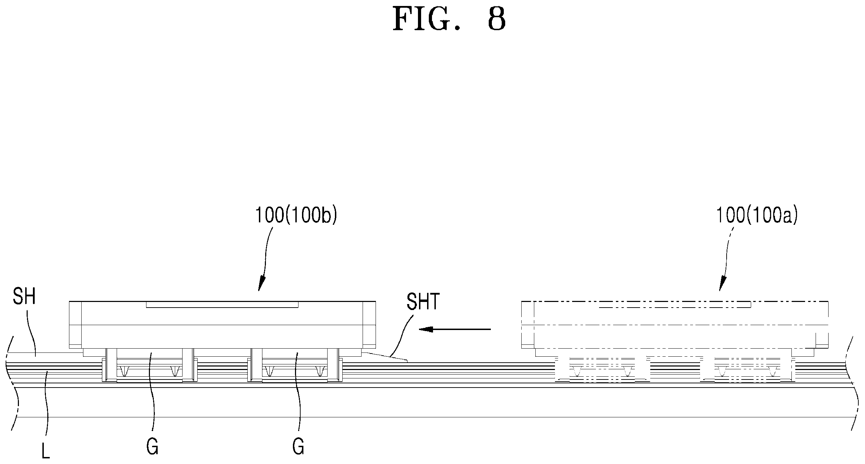

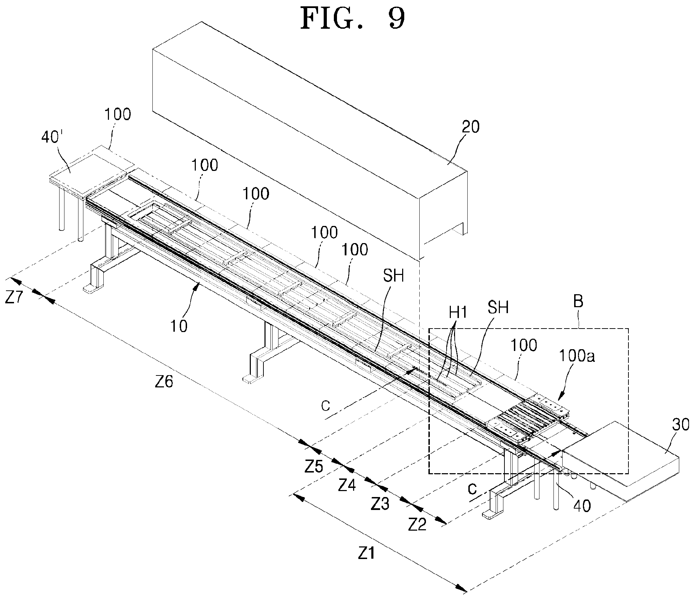

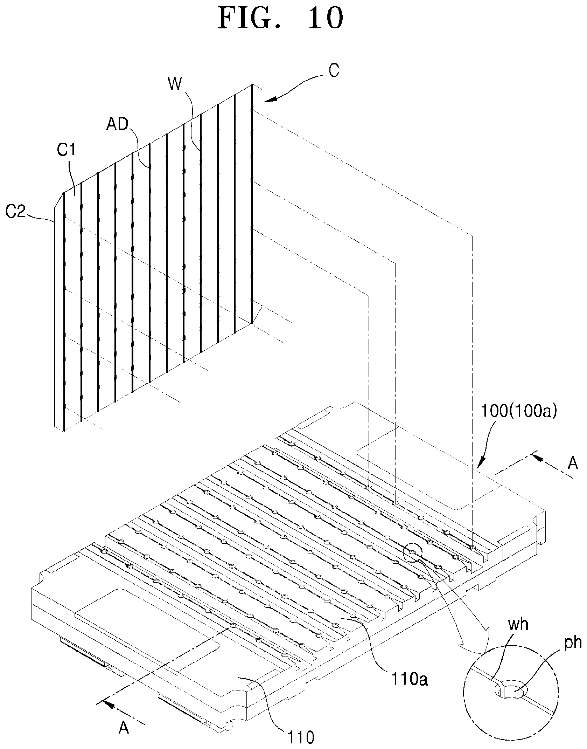

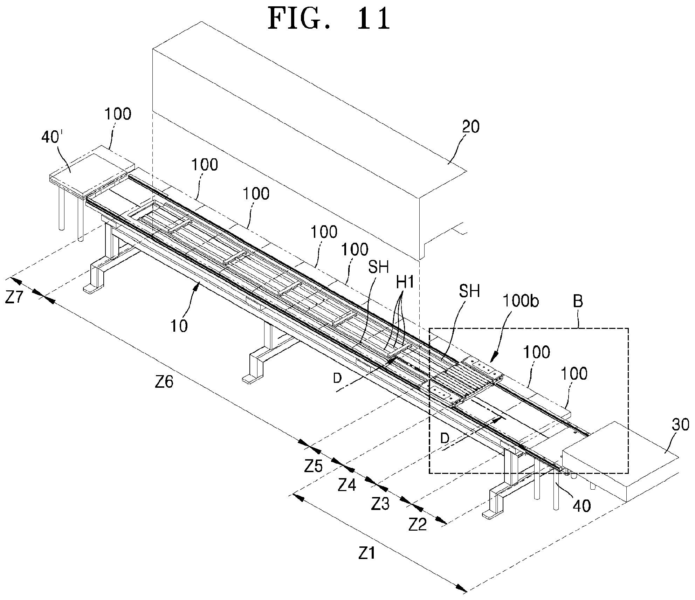

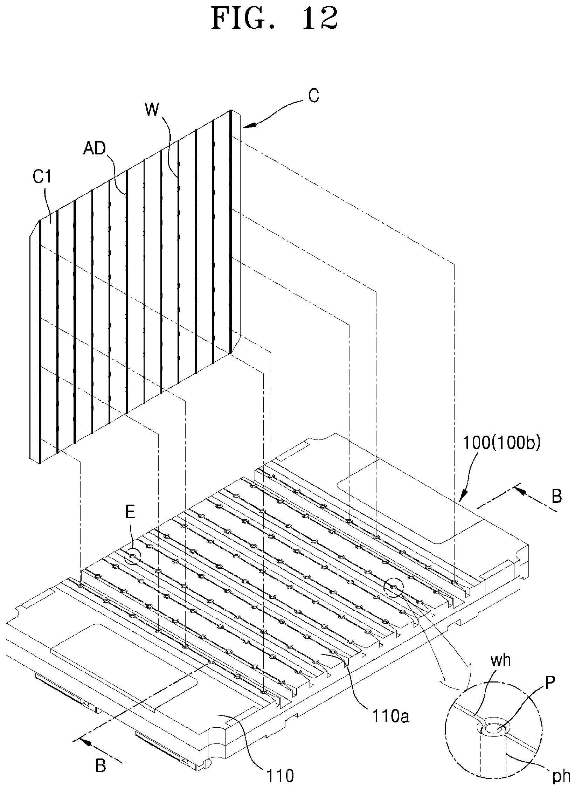

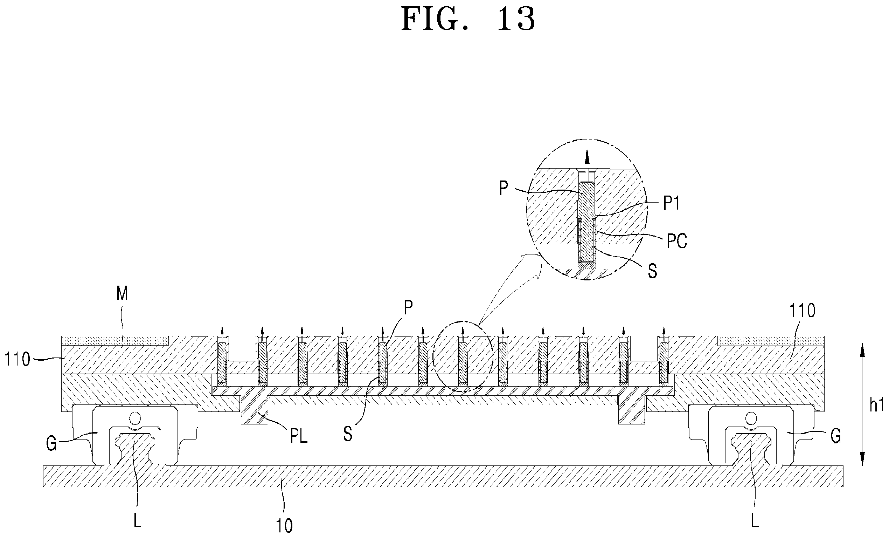

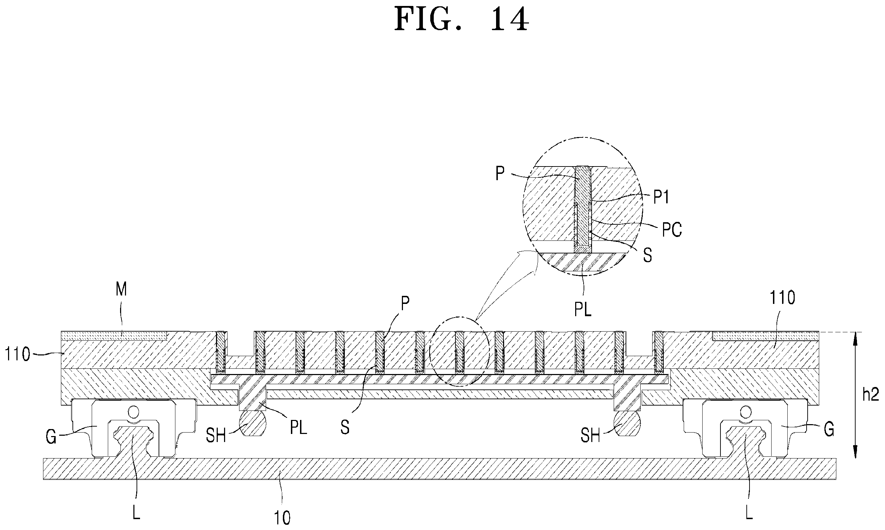

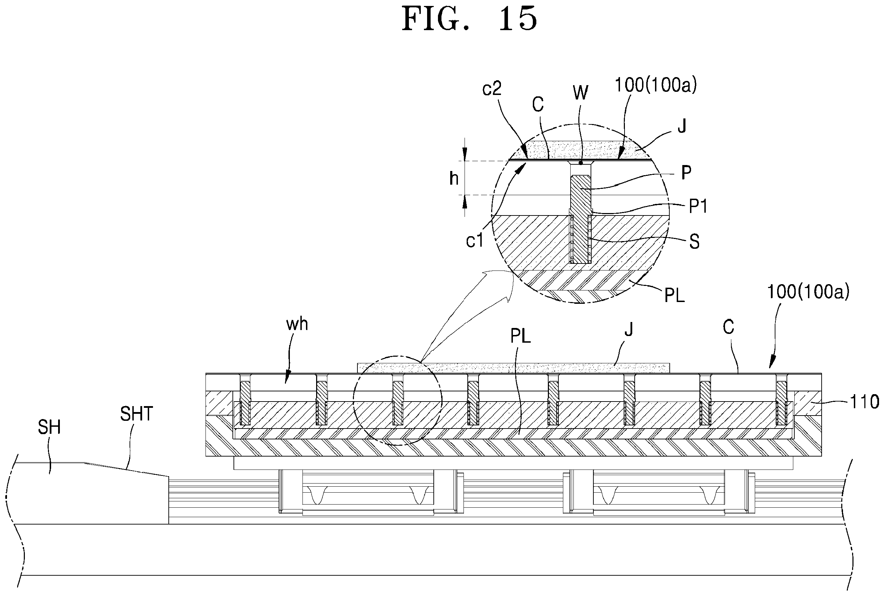

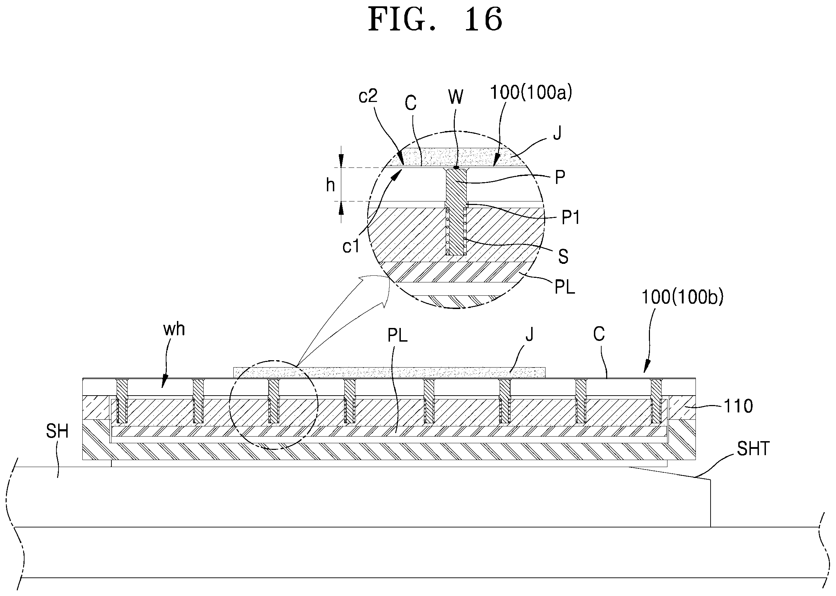

FIG. 1 is an overall conceptual view of a solar cell manufacturing apparatus according to one embodiment of the present invention. FIG. 2 is view sequentially illustrating a process of connecting solar cells and wires according to one embodiment of the present invention. FIG. 3 is a perspective view of a solar cell manufacturing apparatus according to one embodiment of the present invention. FIG. 4 is a perspective view of the solar cell manufacturing apparatus including the curing unit according to one embodiment of the present invention, illustrating a stage placed therein. FIG. 5 is a bottom view of Part A1 of FIG. 4, that is, the curing unit. FIG. 6 is a top view of Part A2 of FIG. 4, that is, a base. FIG. 7 is an enlarged view of Part B of FIG. 4. FIG. 8 is a side view of the stage according to the embodiment of the present invention, showing the stage moved to mount a shaft. FIG. 9 is a perspective view of the solar cell manufacturing apparatus according to the embodiment of the present invention before the stage mounts the shaft. FIG. 10 is an exploded perspective view of the stage and a solar cell seated on the stage shown in FIG. 9. FIG. 11 is a perspective view of the stage mounted on the shaft according to the embodiment of the present invention. FIG. 12 is an exploded perspective view of the stage and a solar cell seated on the stage shown in FIG. 11. FIG. 13 is a cross-sectional view taken along line A-A in FIG. 10, showing the stage before the stage is mounted on the shaft. FIG. 14 is a cross-sectional view taken along line B-B in FIG. 12, showing the stage after the stage is mounted on the shaft. FIG. 15 is a cross-sectional view taken along line C-C in FIG. 9, showing the stage before the stage is mounted on the shaft. FIG. 16 is a cross-sectional view taken along line D-D in FIG. 11, showing the stage after the stage is mounted on the shaft.

A solar cell manufacturing apparatus is a device for connecting solar cells C and a wire w to form a solar cell module. The solar cell C includes a semiconductor junction region having a p-n junction surface, and when irradiated with a certain magnitude or more of energy, the solar cell C generates electromotive force to convert light energy into electrical energy. A semiconductor material included in the solar cell C is not limited to a particular material and may include silicon (monocrystalline, polycrystalline, and amorphous silicon), gallium arsenide, cadmium telluride, cadmium sulfide, indium phosphorus, copper indium gallium selenide (CIGS), organic dyes, or mixtures thereof.

The wire w is a conductor for electrically connecting a plurality of solar cells C to each other and is configured to connect front and back surfaces of adjacent solar cells C to each other. For example, the wire w may be electrically connected to the solar cells C through a curing process. Alternatively, the wires w may be electrically connected to the solar cells C through an electrically conductive adhesive (ECA).

Referring to FIG. 1 to FIG. 16, the solar cell manufacturing apparatus according to the embodiment of the present invention includes: a solar cell C on which a wire w is disposed; a stage on which the solar cell C is seated; and a shaft SH disposed under the stage 100 to be placed on a traveling path of the stage 100, wherein the stage 100 includes: a body 110; a plate PL disposed within the body 110 to move upwards or downwards and adjoining the shaft SH disposed under the stage 100; and a plurality of pins P seated on an upper surface of the plate PL, and wherein, upon movement of the stage 100, the stage 100 is moved to be mounted on the shaft SH, the shaft SH pushes the plate PL upwards with the plurality of pins P seated on the plate PL, and upper surfaces of the plurality of pins P bring the wire w into contact with a surface C1 of the solar cell C while moving upwards. In the solar cell C manufacturing apparatus according to this embodiment, a plurality of stages 100 is continuously connected and moved, as shown in FIG. 3. However, for convenience of description, only movement of a single stage 100 among the plurality of stage 100s will be described by way of example in FIG. 8 to FIG. 16.

Referring to FIG. 1, a curing process may be performed while the solar cells C pass through the curing unit 20 with each of the solar cells C seated on the stage 100. The solar cells C may be fed through a cell feeder 80. The cell feeder 80 may feed the solar cells C with an electrically conductive adhesive (ECA) applied thereto.

The cell feeder 80 may convey the solar cells C with the electrically conductive adhesive applied thereto to a cell-jig feeder 90. In addition, a jig feeder 70 may be disposed at a side opposite the cell feeder 80 with reference to the cell-jig feeder 90 to feed jigs J to the cell-jig feeder 90.

The cell-jig feeder 90 may convey the solar cell C and the jig J to an upper side of the base 10 through a cell-jig conveying unit 91. The cell-jig conveying unit 91 may grip the solar cell C and the jig J together and may rotationally shift the solar cell C and the jig J around a rotational shaft 91a to place the solar cell C and the jig J on the upper side of the base 10. Then, the solar cell C and the jig J disposed on the upper side of the base 10 may be sequentially seated on the stage 100, which in turn may enter a curing zone Z6 together with the solar cell C and the jig J seated thereon to be subjected to the curing process.

A stage feeding zone Z2 may be provided with a stage feeder 40. The stage feeder 40 may feed the stage 100 to the stage feeding zone Z2. The solar cell C and the jig J may be seated on the stage 100 fed to the stage feeding zone Z2 and the stage 100 may pass through the curing zone Z6 together with the solar cell C and the jig J seated thereon to allow the curing process for the solar cell C to be performed.

On the stage 100 having passed through the curing zone Z6 and an outlet zone Z7 described below, the jig J may be separated and retrieved from the stage 100 and the solar cell C by a jig retrieval unit 71. The solar cell C seated on the stage 100 from which the jig J is separated may be separated and discharged from the stage 100 through a cell conveying unit 50. The jig retrieval unit 71 may feed the retrieved jig to the jig feeder 70, which in turn may refeed the retrieved jig to the cell-jig feeder 90.

The stage 100 from which the jig J and the solar cell C are separated may be retrieved by a stage retrieval unit 40'. The stage retrieval unit 40' is connected to the stage feeder 40 and the stage 100 retrieved through the stage retrieval unit 40' may be conveyed to the stage feeder 40. The stage feeder 40 may refeed the conveyed stage 100 to the stage feeding zone Z2.

The stage 100 may be conveyed on the base 10 from the stage feeding zone Z2 to the outlet zone Z7. The stage 100 may be conveyed from the stage feeding zone Z2 to a solar cell seating zone Z3. In the solar cell seating zone Z3, the solar cell C fed from the cell-jig feeder 90 may be seated on the stage 100 by the cell-jig conveying unit 91.

With the solar cell C seated on the stage 100, the stage 100 may be conveyed from the solar cell seating zone Z3 to a jig securing zone Z4. In the jig securing zone Z4, the solar cell C may be secured to the stage 100 as soon as the jig J is seated on the stage 100.

With the solar cell C and the jig J seated on the stage 100, the stage 100 may be conveyed from the jig securing zone Z4 to a pre-heating zone Z5. In the pre-heating zone Z5, the solar cell C seated on the stage 100 may be pre-heated through the first heater H1 disposed in the pre-heating zone Z5, prior to the curing process.

With the solar cell C and the jig J seated on the stage 100, the stage 100 may be conveyed from the pre-heating zone Z5 to the curing zone Z6. After entering the curing zone Z6, the solar cell C seated on the stage 100 may be subjected to the curing process.

After passing through the curing zone Z6, the stage 100 with the solar cell C and the jig J seated thereon may be conveyed to the outlet zone Z7. In the outlet zone Z7, the first heater H1 may be disposed to act as a temperature buffering feature to prevent the solar cell C from undergoing a sudden temperature change by slowly reducing a temperature of the solar cell C seated on the stage 100 when the stage 100 is discharged from a high temperature environment in the curing zone Z6.

The stage 100 may be conveyed to the stage retrieval unit 40' through the outlet zone Z7. Here, the jig J may be separated and retrieved from the stage 100 and the solar cell C through the jig retrieval unit 71. The jig retrieval unit 71 may be disposed in a region corresponding to the stage retrieval unit 40'. Accordingly, the jig retrieval unit 71 may retrieve the jig J disposed on the stage retrieval unit 40'. Alternatively, the jig retrieval unit 71 may be placed between the outlet zone Z7 and the stage retrieval unit 40'. Accordingly, the jig retrieval unit 71 may retrieve the jig J disposed in a region corresponding to a jig retrieval region.

In addition, the solar cell C seated on the stage 100 from which the jig J is retrieved may be separated and discharged from the stage 100 through the cell conveying unit 50. Then, the stage 100 may be delivered to the stage feeder 40 through the stage retrieval unit 40' and may be refed to the stage feeding zone Z2.

A wire feeder 30 may be disposed at one side of the stage feeding zone Z2. The wire feeder 30 may extend and convey wires w to the stage feeding zone Z2, the solar cell seating zone Z3, and the jig securing zone Z4 through a gripper to secure the wire w. Here, the extending wire w may be guided by a wire groove formed on the stage 100. Thus, the wire feeding zone Z1 may be a region including the wire feeder 30, the stage feeding zone Z2, the solar cell seating zone Z3, and the jig securing zone Z4.

The wires w may be disposed on upper and lower surfaces of the solar cell C. The wire w disposed on the lower surface of the solar cell C may be guided by the wire groove formed on the stage 100. The wire w disposed on the upper surface of the solar cell C may be secured thereto by the jig J by pressing the wire w onto the upper surface of the solar cell C. The jig J may secure the wire w such that the wire w does not lift or deviate from a specific location when connecting the wire w to the upper surface of the solar cell C.

The wire feeder 30 may include a cutter configured to cut a rolled wire to a preset first length and a gripper configured to extend and convey the wire of the first length to the jig securing zone Z4 through the stage feeding zone Z2 and the solar cell seating zone Z3.

Referring to FIG. 2, in order to perform the curing process, the stages 100 are fed to the stage feeding zone Z2 and the solar cell seating zone Z3 ((a) of FIG. 2) and, when a first wire w1 is fed by the wire feeder 30 ((b) of FIG. 2), the cell-jig conveying unit 91 simultaneously seats a pair of a first solar cell C1 and a first jig J1 on the first wire w1 ((C) of FIG. 2). At this time, the cell-jig conveying unit 91 seats the first solar cell C in the solar cell seating zone Z3 and seats the first jig J in the jig securing zone Z4.

Then, the stages 100, the first wire w1, the first jig J1, and the first solar cell C1 are conveyed on the base 10 to the curing zone Z6 by one pitch P and a second wire w is fed onto the conveyed solar cell C ((d) in FIG. 2).

Referring to FIG. 3, the pitch P may be a width P of the stage. Here, the pre-heating zone may have a width Z5 corresponding to the width P of the stage. Specifically, each of the width Z5 of the pre-heating zone and the width P of the stage may refer to a width in a direction parallel to a conveying direction of the solar cell C.

Then, the cell-jig conveying unit 91 simultaneously seats a pair of a second jig J2 and a second solar cell C2 on the second wire w2 ((e) of FIG. 2).

Referring again to FIG. 1, the jig and the solar cell on the stage 100 placed at the stage retrieval unit 40' are picked up to be separated from the stage 100 by the jig retrieval unit 71 and the cell conveying unit 50, respectively.

Then, the first wire w1, the first jig J1, the first solar cell C1, the second wire w2, the second jig J2, and the second solar cell C2 are conveyed on the base 10 to the curing zone Z6 by one pitch P and a third wire w3 is fed onto the conveyed solar cell C ((f) of FIG. 2).

Then, the cell-jig conveying unit 91 simultaneously seats a pair of a third jig J3 and a third solar cell C3 on the third wire w3 ((g) in FIG. 2). Referring again to FIG. 1, the jig and the solar cell on the stage 100 placed at the stage retrieval unit 40' are picked up and separated from the stage 100 by the jig retrieval unit 71 and the cell conveying unit 50, respectively.

In the above order, the wires w and the jigs J are disposed on the solar cells C on the stages 100 and the curing process may proceed in the curing zone Z6 with the wires w bonded to the upper and lower surfaces of the solar cell C.

The stage 100 may convey the solar cell C and the wire w disposed on the solar cell C to the curing zone Z6. The stage 100 may enter the curing zone Z6 through rails L formed on opposite sides of the base 10 and may exit the curing zone Z6 through the rails L. Referring to FIG. 3, a plurality of stages 100 may be continuously fed to the curing zone Z6 in a connected state.

The plurality of stages 100 may be provided with a plurality of solar cells C each having the wires w thereon, respectively. As shown in FIG. 2, a wire disposed on an upper surface of one solar cell C may extend to be disposed on a lower surface of another solar cell C connected to one solar cell C. In addition, a wire disposed on a lower surface of the one solar cell C may extend to be disposed on an upper surface of another solar cell C connected to the one solar cell C. Here, both the upper surface and the lower surface of one solar cell C may have the wires disposed thereon.

The base 10 on which the stage 100 is conveyed is formed in an elongated shape such that the stage 100 can be moved into the curing zone Z6 on the base 10. The stage 100 is formed at a lower end thereof with a guide G, which remains in a connected state with the rails L formed on the base 10 and allows the stage 100 to move along the rails L.

Between the rails L formed on the opposite sides of the base 10, two shafts SH may be formed parallel to the rails L. When the stage 100 is conveyed along the rails L, the stage 100 may be conveyed, with the lower end of the stage 100 contacting the shafts SH.

Each of the rails L extends from one end of the base 10 to the other end thereof in a longitudinal direction thereof. On the other hand, the shafts SH extend to pass through the pre-heating zone Z5, the curing zone Z6, and the outlet zone Z7.

According to this embodiment, the manufacturing apparatus may further include a first heater H1 disposed between the two shafts SH on an upper surface of the base 10. In this embodiment, the first heater H1 is composed of three heaters and has a pipe structure extending in the longitudinal direction parallel to the shafts SH. However, it should be understood that the number and shape of the first heater H1 are not limited thereto.

The first heater H1 may have a length corresponding to the shafts SH. Thus, like the shafts SH, the first heater H1 extends through the pre-heating zone Z5, the curing zone Z6, and the outlet zone Z7. In this structure, a process of pre-heating the solar cell C may be performed in the pre-heating zone Z5, a process of curing the solar cell C may be performed in the curing zone Z6, and a process of relieving a temperature difference between the curing zone Z6 and the outside may be performed in the outlet zone Z7.

According to this embodiment, the first heater H1 may be a cartridge type heater.

The stage 100 having the solar cell C seated thereon may pass above the first heater H1. The first heater H1 may perform the curing process with respect to the solar cell C seated on the stage 100 while the stage 100 passes above the first heater H1.

The curing unit 20 is disposed above the base 10. The curing unit 20 is formed in a box shape open at a lower surface thereof. The curing unit 20 may be formed in an elongated shape in the longitudinal direction of the base 10 so as to cover a central portion of the base 10.

The curing unit 20 may be disposed to cover the curing zone Z6 of the base 10. However, in the event of failure or maintenance of the curing unit 20, the curing unit 20 may be opened to allow maintenance work to be performed on the interior of the curing unit 20.

A plurality of solar cells C disposed inside the curing unit 20 coupled to the central portion of the base 10 may be cured inside the curing unit 20, with each solar cell C seated on the corresponding stage 100. The curing unit 20 may be formed to accommodate as many stages 100 with the solar cells C seated thereon as possible in order to maximize the number of solar cells C to be cured.

Referring to FIG. 5, the curing unit 20 may be provided on an interior ceiling 21 thereof with a plurality of second heaters H2. According to this embodiment, the second heater H2 is composed of four heaters and has a pipe structure extending in a longitudinal direction parallel to the longitudinal direction of the curing unit 20. However, it should be understood that the number and shape of the second heater H2 are not limited thereto.

According to this embodiment, the second heater H2 may be an infrared (IR) heater.

The second heater H2 is disposed only in the curing zone Z6 and the first heater H1 having a greater length than the second heater H2 is disposed not only in the curing zone Z6 but also in the pre-heating zone Z5. The solar cell placed in the pre-heating zone Z5 is pre-heated by the first heater H1 in the pre-heating zone Z5 and may enter a curing space defined by the curing unit 20. In other words, the solar cell may enter the curing zone Z6 in a pre-heated state before the curing process, thereby improving quality of the cured solar cell C. Here, each of the first length L1 and the second length L2 refers to a length in a first direction, which is a length in a longitudinal axis direction of the first and second heaters H1, H2 corresponding to the conveying direction of the solar cells C on the base 10.

Here, the pre-heating zone Z5 may have a width corresponding to the width P of the stage. Thus, after being pre-heated in the pre-heating zone Z5, the stage 100 having the solar cell C seated thereon enters a space defined by the curing unit 20, and another stage 100 connected to the stage 100 that has entered the curing unit 20 is placed in the pre-heating zone Z5 such that another solar cell C seated on the other stage 100 can be pre-heated.

Referring to FIG. 3 and FIG. 4, the base may include the outlet zone Z7 to which the stage 100 having the solar cell C seated thereon is conveyed from the curing zone Z6. Here, the first heater H1 may be disposed in the curing zone Z6, the pre-heating zone Z5, and the outlet zone Z7. That is, the first heater H1 may extend beyond both ends of the second heater H2. After the curing process, the solar cell C conveyed out of the curing unit 20 may be subjected to post-heating by the first heater H1 in the outlet zone Z7. That is, the first heater H1 may be disposed in the outlet zone Z7 such that the solar cell C seated on in the stage 100 does not undergo a sudden temperature change when the stage 100 is conveyed from a high temperature environment in the curing zone Z6 to the outside of the curing zone Z6. The first heater H1 disposed in the outlet zone Z7 can play a temperature buffering role to slowly reduce the temperature of the solar cell C disposed on the stage 100. As a result, quality of the cured solar cell can be further improved.

According to this embodiment, the shaft SH may be formed at a distal end thereof with a chamfered portion SHT. The chamfered portion SHT may be disposed in the pre-heating zone Z5. The chamfered portion SHT may form an inclined surface from an upper surface of the base 10 to an upper surface of the shaft SH in a direction in which the curing zone Z6 is located.

The plate PL of the stage 100a fed into the stage feed zone Z2 through the stage feeder 40 may be disposed at a first height. Such a stage 100a may pass through the chamfered portion SHT of the shaft SH. With respect to the body 110 of the stage 100, the plate PL of the stage 100b seated on the shaft SH after passing through the chamfered portion SHT may be disposed at a second height that is higher than the location of the plate PL of the stage 100a before riding up the shaft SH, that is, the first height.

The plate PL of the stage 100 may contact the chamfered portion SHT of the shaft SH. Here, the plate PL may be formed as an upwardly or downwardly movable structure within the stage 100. Thus, as the stage 100 passes through the chamfered portion SHT, the plate PL in contact with the chamfered portion SHT may be moved upwards as the stage 100 is moved to be mounted on the chamfered portion SHT. Since the plate PL moves in contact with the shaft SH after passing through the chamfered portion SHT, the plate PL may pass through the curing zone Z6 while remaining in an upwardly moved state, as compared to before passing through the chamfered portion SHT. After passing through the curing zone Z6, the plate PL of the stage 100 may be moved downwards again after passing the other end of the shaft SH.

According to this embodiment, the plurality of pins P is seated on the plate PL. Accordingly, when the plate PL is moved upwards or downwards, the plurality of pins P may also be moved together with the plate PL. The plurality of pins P may be raised through pin insertion holes ph formed in the body 110 that is in a stationary state. The plurality of pins P raised upwards may push the wire w disposed on a surface C1 of the solar cell C seated on an upper surface of the body 110 to contact the surface C1 of the solar cell C. In this way, when the solar cell C is introduced into a soldering zone Z1, a soldering process may be performed while the wire w disposed on the surface C1 of the solar cell C remains in contact with the surface C1 of the solar cell C.

The chamfered portion SHT of the shaft SH is formed in the pre-heating zone Z5. Thus, in the pre-heating zone Z5, the plate PL within the stage 100 may be mounted on the shaft SH along the chamfered portion SHT disposed in the pre-heating zone Z5. In addition, the plurality of pins P seated on the upper surface of the plate PL may also be raised together with the plate PL in the pre-heating zone Z5. That is, referring to FIG. 13 and FIG. 14, a second height h2 of the upper surfaces of the plurality of pins P relative to the base 10 in the pre-heating zone Z5 may be higher than a first height h1 of the upper surfaces of the plurality of pins P relative to the base 10 in the solar cell seating zone Z3 and the jig securing zone Z4

That is, the plurality of pins P raised upwards may press the wire w against the lower surface of the solar cell C under the lower surface of the solar cell C while maintaining the second height h2. After the curing process is completed, the stage 100 is conveyed to the outlet zone Z7. Here, the shaft SH extends from the pre-heating zone Z5 to the outlet zone Z7 through the curing zone Z6. Thus, in the outlet zone Z7, the plate PL is raised upwards by the shaft SH and the plurality of pins P is also raised upwards, whereby the plurality of pins P can still press the wire w against the lower surface of the solar cell C even in the outlet zone Z7.

After the stage 100 passes through the outlet zone Z7, the shaft SH is no longer disposed at a lower side of the stage 100. Thus, the plate PL and the plurality of pins P may also be lowered by gravity and the plurality of pins P may be separated from the wire w contacting the lower surface of the solar cell C.

Thus, when the stage 100 reaches the stage retrieval unit 40' after passing through the outlet zone Z7, force applied to the lower surface of the solar cell C on the stage 100 by the plurality of pins P may be removed together with force applied to the upper surface of the solar cell C by the jig retrieval unit 71. Accordingly, the solar cell C becomes detachable from the stage 100 and may be separated from the stage 100 while being conveyed to the cell conveying unit 50.

The plurality of pins P mounted on the stage 100 is disposed such that the upper surfaces of the plurality of pins P have the first height h1 as a default position relative to the base 10 in the solar cell seating zone Z3 and the jig securing zone Z4. However, while the stage 100 passes through the pre-heating zone Z5, the curing zone Z6, and the outlet zone Z7, the plurality of pins P is raised by the shaft SH disposed in the pre-heating zone Z5, the curing zone Z6, and the outlet zone Z7, whereby the upper surfaces of the plurality of pins P are disposed to have the second height h2 higher than the first height h1 relative to the base 10. Then, after passing through the outlet zone Z7, the plurality of pins P in the stage 100 may move downwards again at a location where the shaft SH is not present, whereby the upper surfaces of the plurality of pins P have the first height h1 relative to the base 10.

In this way, the wire w may remain in contact with the lower surface C1 of the solar cell C simply through a pin-up process via the shaft SH during the process of conveying the stage 100 with the solar cell C mounted thereon into the soldering zone Z1. In addition, the wire w may remain in contact with the upper surface of the solar cell C through the jig J described above. As such, the solar cell manufacturing apparatus according to the embodiment has an advantage that the soldering process can be performed with the wire w automatically maintained in a secured state on both surfaces of the solar cell C even through such a simple mechanical device.

In addition, the process of securing the wire w to the surface of the solar cell C does not require a separate power source, thereby providing an advantage of cost and energy reduction.

In addition, there are no mechanical interference factors from other parts in the process of moving the plurality of pins upwards. Further, since the plurality of pins is moved upwards only through the shaft, there are no interference factors, such as vibration and the like, due to use of a separate power source, thereby providing a stable multi-pin lifting structure. With this structure, it is possible to ensure product quality in a solar cell manufacturing process.

As the plate PL is gradually raised upwards along the chamfered portion SHT, the plurality of pins P may also be gradually moved upwards while the plate PL moves upwards along the chamfered portion SHT.

According to this embodiment, the plurality of pins P may be disposed in a plurality of internal spaces within pin cases PC. The internal spaces of the pin cases PC may be formed in a vertical direction and each of the plurality of pins P may be formed to move upwards or downwards in the corresponding internal space. In addition, the internal spaces of the pin cases PC may restrict movement locations of the plurality of pins P such that the plurality of pins P can be moved only in the vertical direction.

The pins P may have a cylindrical shape, an upper side of which has a greater diameter than a lower side thereof. The pin P is formed at an upper side thereof with a pin jaw P1 and a spring S is disposed under the pin jaw P1. The spring S may be formed to wrap around a lower side of the pin P, the plate PL may be disposed at a lower side of the spring S, and the pin jaw P1 may be disposed at an upper end of the spring S. The spring S acts to buffer pressing force when the pin P presses the wire w and can prevent the wire w from breaking due to the pressing force of the pin P.

Referring to FIG. 10, a solar cell C according to one embodiment of the present invention may include a lower surface C1, a plurality of wires w disposed on the lower surface C1, and a plurality of electrically conductive adhesive members AD disposed between the plurality of wires w and the lower surface C1 and arranged at certain intervals. The plurality of electrically conductive adhesive members AD is formed on the surface of the solar cell C.

The plurality of pins P may be disposed at locations corresponding to the plurality of electrically conductive adhesive members AD. The plurality of pins P may be raised by the plate PL to press portions of the solar cell C on which the plurality of electrically conductive adhesive members AD is disposed. The plurality of wires w may be disposed between any one of the plurality of pins and any one of electrically conductive adhesives ECA and may be bonded to the electrically conductive adhesives ECA by compression of the pins.

Next, referring to FIG. 15 to FIG. 17, the periphery of the plurality of pins according to the embodiment of the present invention will be described. For details and description of components not shown in FIG. 15 to FIG. 17, refer to FIG. 1 to FIG. 15 and the description thereof.

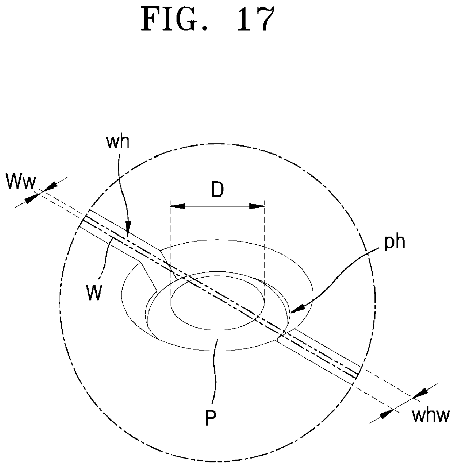

FIG. 15 is a cross-sectional view taken along line C-C of FIG. 9, showing the stage before the stage is mounted on the shaft. FIG. 16 is a cross-sectional view taken along line D-D of FIG. 11, showing the stage after the stage is mounted on the shaft. FIG. 17 is an enlarged perspective view of Part E of FIG. 12, showing the pins moved upwards.

Referring to FIG. 15 to FIG. 17, the body 110 of the stage 100 according to one embodiment of the present invention may include wire insertion holes wh into which the wires w disposed on the solar cell C are inserted and pin insertion holes ph into which a plurality of pins P is inserted. The wire insertion holes wh and the pin insertion holes ph may be recessed downwards from a stage upper surface 110a of the body 110. The wire insertion holes wh may be formed in a direction parallel to a longitudinal direction of the wires at locations corresponding to the plurality of wires w disposed on the solar cell C such that the wires w can be inserted into the wire insertion holes wh, respectively. Furthermore, each of the pin insertion holes ph may be formed to have a greater width than the wire insertion hole wh and may have a hollow shape such that the pins P each disposed within the pin insertion hole ph can be moved up or down through the pin insertion holes ph, respectively.

Here, each of the wire insertion holes wh shown in FIG. 15 and FIG. 16 may have a depth h ranging from about 5 times to about 10 times a width Ww of the wire. For example, the depth h of the wire insertion hole wh may be 5, 6, 7, 8, 9, or 10 times the width Ww of the wire. Since the wire w can be stretched away from the lower surface C1 of the solar cell C and the wire insertion hole wh will receive the stretched wire w before the wire w is adhesively bonded to the electrically conductive adhesive ECA, the wire insertion holes wh may have a depth h that can accommodate the stretched wires w.

If the depth h of the wire insertion holes wh is less than 5 times the width Ww of the wires, it can be difficult for the wire insertion holes wh to accommodate the wires w in a stretched state and the wires w can be damaged. In addition, if the depth h of the wire insertion holes wh is greater than 10 times the width Ww of the wires, there is a concern of deterioration in durability of the body 110 with a deep gap formed through the wire insertion holes wh.

The wire insertion holes wh may have a width whw ranging from about 1.5 times to about 3 times the width Ww of the wires. For example, the width whw of the wire insertion holes wh may be 1.5, 2, 2.5, or 3 times the width Ww of the wires. If the width whw of the wire insertion holes wh is less than 1.5 times the width Ww of the wires, the wires w cannot be inserted into the wire insertion holes wh upon vibration of the wires w. If the width whw of the wire insertion holes wh is greater than 3 times the width Ww of the wires, there is a high probability of introduction of foreign matter into the wire insertion holes (wh) and the body 110 with a wide gap can suffer from deterioration in durability.

According to this embodiment, the plurality of pins P, the pin cases PC each receiving the pin P inserted thereinto, and the springs S each disposed to warp around the pin may be inserted into the pin insertion holes ph, respectively.

According to this embodiment, the plurality of pins P may have a diameter D ranging from about 3 times to about 5 times the width Ww of the wires. For example, the diameter D of the plurality of pins P may be 3, 3.5, 4, 4.5, or 5 times the width Ww of the wires. If the diameter D of the pins P is less than 3 times the width Ww of the wire, the pins P can fail to properly press the wires w upon vibration of the wires when the pins P are raised. If the diameter D of the pins P is greater than 5 times the width Ww of the wires, an area occupied by the pins P becomes large to increase the volume of the pin insertion holes ph each accommodating the pin P, thereby causing deterioration in durability of the body 110 due to increase of a hollow region.

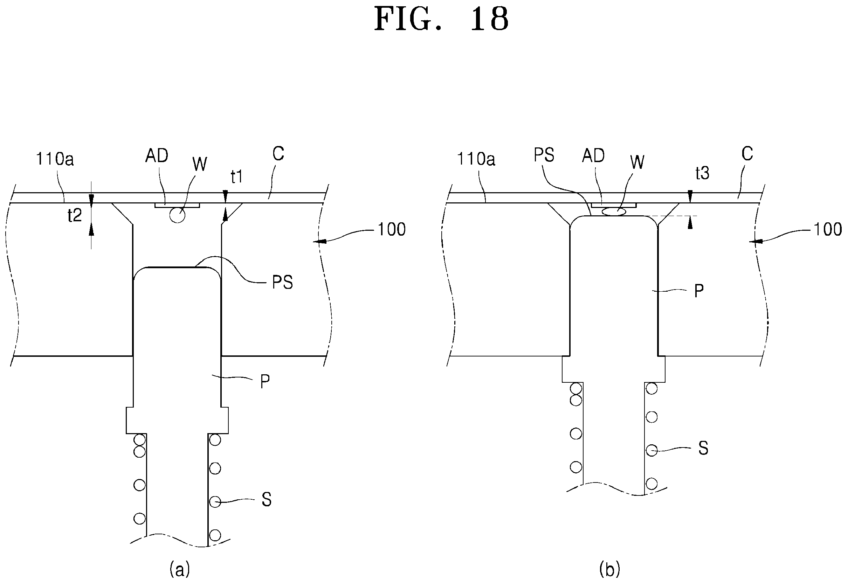

Next, with reference to FIG. 18(a) and FIG. 18(b), a relationship between the thickness of the electrically conductive adhesive ECA, the thickness of the wire, and the thickness between the upper surfaces of the pins and the upper surface of the stage upon compression of the solar cell by the plurality of pins according to the embodiment of the invention will be described. For details and description of components not shown in FIG. 18(a) and FIG. 18(b), refer to FIG. 1 to FIG. 17 and the description thereof.

FIG. 18(a) is an enlarged cross-sectional view of Part E of FIG. 12, showing a thickness of each component with the pin moved downwards. FIG. 18(b) is an enlarged cross-sectional view of Part E of FIG. 12, showing the thickness of each component with the pin moved upwards.

Referring to FIG. 18(a) and FIG. 18(b), in the solar cell manufacturing apparatus according to the embodiment of the invention, a thickness t3 between the upper surface PS of each of the plurality of pins P moved upwards and the upper surface 110a of the stage may be less than a thickness t2 of the wire.

If the thickness t3 between the upper surface PS of each of the plurality of pins P and the upper surface 110a of the stage is greater than the thickness t2 of the wires w, the upper surfaces PS of the plurality of pin P can be spaced apart from the wires w. Therefore, the wires w cannot be secured through the upper surfaces PS of the pins and the function of the plurality of pins P cannot be expressed.

According to this embodiment, the thickness t3 between the upper surfaces PS of the plurality of pins P and the upper surface 110a of the stage may have a preset ratio with respect to the thickness t2 of the wires w. This structure is designed to prevent breakage of the wires w and the solar cell C due to excessive lifting of the plurality of pins P and to secure the wires w more effectively.

For example, the thickness t3 between the upper surfaces PS of the plurality of pins P and the upper surface 110a of the stage may range from about 60% to about 90% of the thickness t2 of the wires w. For example, the thickness t3 between the upper surfaces PS of the plurality of pins P and the upper surface 110a of the stage may be about 60%, 70%, 80%, or 90% of the thickness t2 of the wires w. If the thickness t3 between the upper surfaces PS of the plurality of pins P and the upper surface 110a of the stage is less than 60% of the thickness t2 of the wires w, the plurality of pins P can excessively press the wires w, causing breakage of the wires w and the solar cell C. If the thickness t3 between the upper surfaces PS of the plurality of pins P and the upper surface 110a of the stage is greater than 90% of the thickness t2 of the wires w, the wires w can be displaced from preset locations during conveyance of the stage 100, thereby making it difficult for the wires w to be joined to the solar cell C at the preset locations.

Referring to FIG. 18(a) and FIG. 18(b), in the solar cell manufacturing apparatus according to the embodiment of the invention, the thickness t3 between the upper surfaces PS of the plurality of pins P moved upwards and the upper surface 110a of the stage may be less than the sum of the thickness t2 of the wire and the thickness t1 of the electrically conductive adhesive ECA.

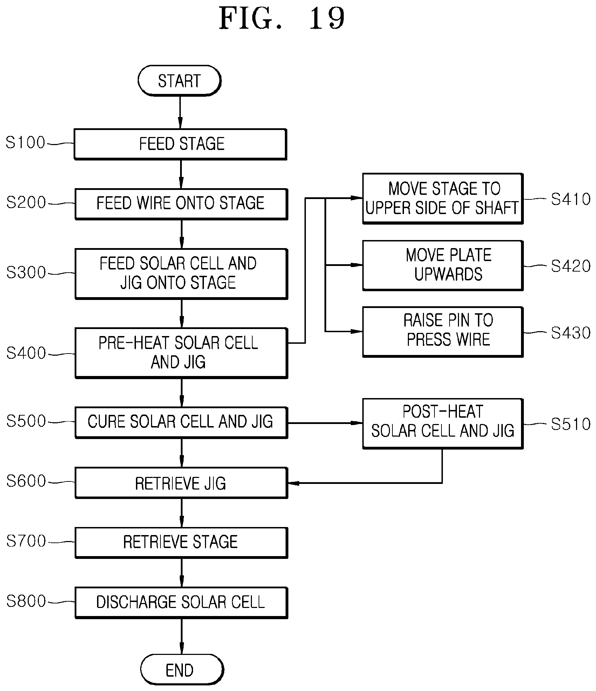

Next, a solar cell manufacturing method according to one embodiment of the present invention will be described with reference to FIG. 19. For details and description of components not shown in FIG. 19, refer to the details shown in FIG. 1 to FIG. 17, FIG. 18(a) and FIG. 18(b) and description thereof.

FIG. 19 is a flowchart illustrating a solar cell manufacturing method according to one embodiment of the present invention.

Referring to FIG. 19, the solar cell manufacturing method according to the embodiment of the present invention may be performed while a stage 100 is moved by a preset pitch P at a time. For example, as the fed stage 100 is move by the preset pitch P, a wire w, a solar cell C, and a jig J may be disposed on the stage 100 such that processes, such as heating, curing, and discharge, may be sequentially carried out.

The solar cell manufacturing method according to the embodiment may include the steps of: feeding a stage (S100); feeding a wire onto the stage (S200); feeding a solar cell and a jig onto the stage (S300); pre-heating the solar cell and the jig (S400); curing the solar cell and the jig (S500); and discharging the solar cell (S800).

The step of feeding a stage (S100) may refer to the step of feeding the stage. For example, Step S100 may refer to a step in which the stage feeder 40 is raised and feeds a stage 100 to the stage feeding zone Z2. The stage 100 fed in the stage feeding step S100 may be conveyed by one pitch P at a time according to a process sequence.

The step of feeding a wire onto the stage (S200) may be performed after feeding the stage (S100). The step of feeding a wire onto the stage (S200) may refer to a step in which the wire feeder 30 feeds a wire w onto the stage 100. For example, Step S200 may refer to the step of feeding the wire onto the stages 100 placed in the solar cell seating zone Z3 and the jig securing zone Z4. Specifically, in Step S200, the wire feeder 30 may extend the wire w to the stage feeding zone Z2, the solar cell seating zone Z3, and the jig securing zone Z4 through the grippers. Here, the extending wire w may be guided by a wire groove formed on the stage 100.

The step of feeding a solar cell and a jig onto the stage (S300) may be performed after the step of feeding the wire onto the stage (S200). The step of feeding the solar cell and the jig onto the stage (S300) may refer to the step of feeding the solar cell C and the jig J onto the stage 100 on which the wire w is disposed. For example, Step S300 may refer to the step of feeding the solar cell C onto the stage 100 disposed in the solar cell seating zone Z3 and the jig J onto the stage 100 disposed in the jig securing zone Z4. In Step S300, the solar cell C and the jig J may be simultaneously fed to the respective zones by the cell-jig conveying unit 91. Further, the wire w disposed on the solar cell C by the jig J fed in Step S300 may be secured thereto. That is, the wire w1, the solar cell C, the wire w2, and the jig may be sequentially disposed on the stage 100 in the jig securing zone Z4, as shown in (e) of FIG. 2.

The step of pre-heating the solar cell and the jig (S400) may be performed after the step of feeding the solar cell and the jig onto the stage (S300). The step of pre-heating the solar cell and the jig (S400) may refer to a step in which the solar cell C and the wire w disposed on the stage 100 are pre-heated by the first heater H1 in the pre-heating zone Z5. For example, as shown in (f) of FIG. 2, in Step S400, the solar cell C, and the lower and upper wires w1, w2 disposed respectively on the upper and lower surfaces of the solar cell C may be pre-heated by the first heater H1 in the pre-heating zone Z5. Here, the first heater H1 may be disposed on the upper surface of the base 10, which conveys and supports the stage 100 described above.

The step of pre-heating the solar cell and the jig (S400) may include the steps of: moving the stage 100 to an upper side of a shaft SH (S410); moving a plate PL upwards (S420); and raising pins P to press the wire (S410).

Specifically, the step of moving the stage 100 to the upper side of the shaft SH (S410) may refer to a step in which the stage 100 is conveyed to be mounted on the upper side of the shaft SH formed with a chamfered portion SHT. In addition, the step of moving a plate PL upwards (S420) may refer to a step in which the shaft SH pushes the plate PL on the stage 100 upwards as the stage 100 moves to the upper side of the shaft SH. Further, the step of raising pins P to press the wire (S430) may refer to a step in which a plurality of pins mounted on the plate PL is moved upwards and presses the wire disposed on the lower surface of the solar cell C seated on an upper surface of the stage 100 towards a lower surface C1 of the solar cell C.

The step of curing the solar cell and the jig (S500) may be performed after the step of pre-heating the solar cell and the jig (S400). The step of curing the solar cell and the jig (S500) may refer to a step in which the solar cell C and the wires w disposed on the stage 100 are cured by the first and second heaters H1, H2 in the curing zone Z6. For example, in Step S500, the solar cell C and the lower and upper wires w1, w2 disposed respectively on the upper and lower surfaces of the solar cell C may be cured by the first and second heaters H1, H2 in the curing zone Z6. Here, the second heater H2 may be disposed inside the curing unit 20 disposed above the base 10 described above. The stage 100 may be conveyed between the first and second heaters H1, H2. Through Step S500, an electrically conductive adhesive (ECA) deposited on the upper and lower surfaces of the solar cell C may be cured, thereby allowing the wires w1, w2 disposed on the upper and lower surfaces of the solar cell C to be physically and electrically connected to the solar cell C.

The step of discharging the solar cell (S800) may be performed after the step of cuing the solar cell and the jig (S500). In Step S800, the solar cell C having the wires w1, w2 connected to the upper and lower surfaces thereof may be discharged. For example, the solar cell C with the wires w1, w2 connected thereto may be separated and discharged from the stage 100 through the cell conveying unit 50.

The solar cell manufacturing method according to the embodiment of the present invention may further include the step of post-heating the solar cell and the jig (S510). The step of post-heating the solar cell and the jig (S510) may be performed between the step of curing the solar cell and the jig (S500) and the step of discharging the solar cell (S800). For example, Step S510 may refer to the step of post-heating the solar cell C, which has left the curing unit 20 after the curing step S500, with the first heater H1 in the outlet zone Z7. Step S510 may acts as a buffering step by slowly reducing the temperature of the solar cell C having left the curing unit 20 in the outlet zone Z7. Step S510 can prevent the cured solar cell C from undergoing a sudden temperature change, thereby further improving quality of the solar cell C. Furthermore, the plurality of pins P mounted on the plate PL may remain pressing the wires w against the lower surface of the solar cell C even in the outlet zone Z7. That is, the plurality of pins P may remain pressing the wires w until the step of post-heating (S510).

The solar cell manufacturing method according to the embodiment of the present invention may further include the step of retrieving the jig (S600). The step of retrieving the jig (S600) may be performed between the step of curing the solar cell and the jig (S500) and the step of discharging the solar cell (S800). For example, Step S600 may refer to the step of retrieving the jig J placed on the stage 100 after the stage 100 passes through the curing zone Z6 and the outlet zone Z7. Specifically, in Step S600, the jig J disposed on the stage retrieval unit 40' may be separated and retrieved from the stage 100 and the solar cell C through the jig retrieval unit 71. Alternatively, Step S600 may refer to the step of retrieving the jig J disposed in a jig retrieval region (not shown) placed between the outlet zone Z7 and the stage retrieval unit 40'. Here, the jig retrieval unit 71 described above may be disposed in a region corresponding to the jig retrieval region.

The solar cell manufacturing method according to the embodiment of the present invention may further include the step of retrieving the stage (S700). The step of retrieving the stage (S700) may be performed between the step of curing the solar cell and the jig (S500) and the step of discharging the solar cell (S800). For example, Step S700 may refer to the step of retrieving the stage 100 disposed on the stage 100 that has passed through the curing zone Z6 and the outlet zone Z7. Specifically, in Step S700, the stage 100 may be retrieved through the stage retrieval unit 40'. The stage retrieval unit 40' is connected to the stage feeder 40, and the stage 100 retrieved through the stage retrieval unit 40' may be conveyed to the stage feeder 40. The stage feeder 40 may refeed the conveyed stage 100 to the stage feeding zone Z2.

As such, as the stage 100 is sequentially moved through the stage feeding zone Z2, the solar cell seating zone Z3, the jig securing zone Z4, the pre-heating zone Z5, the curing zone Z6, and the outlet zone Z7, the preparation and execution of the curing process with respect to the solar cell C may be performed in sequence.

That is, the processes, in which the wire w is fed to the stage 100, the solar cell C is disposed thereon, the wire w is disposed on both surfaces of the solar cell C, and the jig J presses the wire w disposed on the upper surface of the solar cell C, are sequentially carried out. Then, after the step of pre-heating the solar cell C through the first heater H1, the stage 100, on which the solar cell C with the wire w disposed thereon is seated, enters the curing zone Z6 defined by the curing unit 20 and is subjected to the curing process therein, whereby the curing process can be systematically and stably performed.

Furthermore, after the curing process is completed, the stages and the jigs used to convey the solar cells may be retrieved and refed, thereby enabling recycling of components.

Furthermore, the stage 100 is moved to the pre-heating zone Z5, and the step S500 of pre-heating the solar cell C and the wire w on the stage 100 by the first heater H1 may include the steps of: conveying the stage 100 to be mounted on the upper side of the shaft SH having the chamfered portion SHT thereon (S510); pushing, by the shaft SH, the plate PL mounted on the stage 100 upwards (S520); and pressing, by the plurality of pins mounted on the plate PL and moved upwards, the wire disposed on the lower surface of the solar cell seated on the upper surface of the stage 100 towards the lower surface C1 of the solar cell (S530).

That is, there is need for conveyance of the solar cell C to the curing zone Z6 while maintaining the wire w in contact with the lower surface C1 and the upper surface C2 of the solar cell C in the pre-heating zone Z5, before the curing process is performed in the curing zone Z6.

According to this embodiment, in the jig securing zone Z4, the jig J secures the wire w disposed on the upper surface of the solar cell C to the upper surface C2 of the solar cell C, and, in the pre-heating zone Z5, the plate PL mounted on the shaft SH and the plurality of pins P secure the wire w disposed on the lower surface of the solar cell C to the lower surface C1 of the solar cell C, whereby the solar cell can enter the curing zone Z6, with the wires secured to both surfaces of the solar cell.

In this way, the wires can be brought into contact with both surfaces of the solar cell through the mechanical configuration of the shaft and compression of the jig during conveyance of the stage, thereby allowing the soldering process to be performed with the wires brought into contact with the surfaces of the solar cell using a mechanical structure without a separate power source.

Although the present invention has been described with reference to the embodiments and the drawings, it should be understood that these embodiments are provided by way of illustration only and that various modifications, changes, and alterations can be made without departing from the spirit and scope of the invention. The scope of the invention should be defined by the appended claims.

Specific technical details described in the embodiments are provided by way of example and do not limit the scope of the invention. In order to make the description of the invention concise and clear, descriptions of typical techniques and configurations in the art may be omitted. In addition, connections of lines or connection members between components shown in the drawings are given for illustration of functional connections and/or physical or circuit connections, which may be represented by various alternative or additional functional connections, physical connections, or circuit connections in an actual device. Furthermore, components may not be required for application of the present invention unless specifically stated as "essential," "important," or the like.

The word "the" or similar directives in the description and claims of the invention may refer to both singular and plural, unless otherwise specified. Furthermore, when a range is recited in an embodiment, it is intended to include the invention with individual values within the range (unless indicated otherwise) and means that each individual value constituting the range is recited in the description of the invention. In addition, the steps constituting a method according to an embodiment may be performed in any suitable order, unless an explicit order is stated or unless indicated otherwise. It should be understood that embodiments are not necessarily limited by the order in which the steps are described. The use of any examples or exemplary terms (for example, "and the like") in the embodiments is intended merely to describe the embodiments in detail and is not intended to limit the scope of the embodiments, unless limited by the claims. Furthermore, a person having ordinary knowledge in the art will recognize that various modifications, combinations, alterations, and changes can be made in accordance with design conditions and factors within the scope of the appended claims or equivalents thereto.

## Claims

1. A solar cell manufacturing apparatus comprising:
a solar cell on which a wire is disposed;
a stage on which the solar cell is seated; and
a shaft disposed under the stage to be placed on a traveling path of the stage,
wherein the stage comprises:
a body;
a plate disposed within the body to move upwards or downwards and adjoining the shaft disposed under the stage; and
a plurality of pins seated on an upper surface of the plate, and
wherein, upon movement of the stage, the stage is moved to be mounted on the shaft, the shaft pushes the plate upwards with the plurality of pins seated on the plate, and upper surfaces of the plurality of pins bring the wire into contact with a lower surface of the solar cell while moving upwards.

2. The solar cell manufacturing apparatus according to claim 1, wherein
the shaft is formed at a distal end thereof with a chamfered portion and
the stage is mounted on the shaft along the chamfered portion.

3. The solar cell manufacturing apparatus according to claim 1, further comprising:
a jig configured to press an upper surface of the solar cell,
the jig being brought into contact with the upper surface of the solar cell.

4. The solar cell manufacturing apparatus according to claim 1, wherein
the solar cell comprises:
a surface portion;
a plurality of wires disposed on the surface portion thereof; and
a plurality of electrically conductive adhesive members disposed between the plurality of wires and the surface portion and spaced apart from each other.

5. The solar cell manufacturing apparatus according to claim 4, wherein
the plurality of pins is disposed at locations corresponding to the plurality of electrically conductive adhesive members.

6. The solar cell manufacturing apparatus according to claim 1, wherein
the body comprises:
a wire insertion hole into which the wire disposed on the solar cell is inserted; and
pin insertion holes into which the plurality of pins is inserted.

7. The solar cell manufacturing apparatus according to claim 6, wherein
the wire insertion hole has a depth (h) ranging from about 5 times to about 10 times a width of the wire.

8. The solar cell manufacturing apparatus according to claim 1, wherein
each of the plurality of pins has a diameter (D) ranging from about 3 times to about 5 times the width of the wire.

9. The solar cell manufacturing apparatus according to claim 1, wherein
a thickness (t3) between the upper surfaces of the plurality of pins moved upwards and an upper surface of the stage is less than a thickness (t2) of the wire.

10. A solar cell manufacturing method comprising:
feeding a stage;
feeding a wire onto the stage;
feeding a solar cell and a jig onto the stage fed the wire;
pre-heating the solar cell and the jig on the stage;
curing the solar cell and the jig on the stage; and
discharging the solar cell,
wherein the step of pre-heating the solar cell and the jig on the stage comprises raising a plurality of pins to press the wire.

11. The solar cell manufacturing method according to claim 10, wherein
the stage comprises:
a body;
a plate disposed within the body to move upwards or downwards and adjoining a shaft disposed under the stage; and
a plurality of pins seated on an upper surface of the plate.

12. The solar cell manufacturing method according to claim 11,
wherein the step of pre-heating the solar cell and the jig on the stage comprises:
moving the stage to an upper side of the shaft; and
moving the plate upwards, and
wherein the step of raising a plurality of pins to press the wire comprises:
moving the plurality of pins disposed on the plate upwards to press the wire disposed between the plurality of pins and the solar cell towards a lower surface of the solar cell.

13. The solar cell manufacturing method according to claim 12, further comprising:
post-heating the solar cell and the jig between the step of curing the solar cell and the jig on the stage and the step of discharging the solar cell,
wherein the plurality of pins presses the wire toward the lower surface of the solar cell even in the step of post-heating.
